# EUROPEAN PATENT APPLICATION

(11) **EP 1 959 577 A1**
(43) Date of publication of application: **20.08.2008**
(21) Application number: 06833618.9
(22) Date of filing: 29.11.2006
(51) Int. Cl.: H04B 1/16

(54) **RECEIVING APPARATUS AND DEMODULATING METHOD**

(30) Priority: 09.12.2005 JP 2005356338
(71) Applicant: Pioneer Corporation, Tokyo 153-8654 (JP)
(72) Inventor: YAMAMOTO, Yuji, Kawagoe-shi, Saitama 350-8555 (JP)
(74) Representative: Sajda, Wolf E.
(86) International application number: PCT/JP2006/323814
(87) International publication number: WO 2007/066551

(57) **Abstract**

An object is to demodulate analog modulated and digitally modulated waves, and automatically switch to demodulate the digital modulated wave component when the reception quality becomes good while the analog modulated wave component is being demodulated.

IF filters (1, 2) extract the analog modulated wave component and the digital modulated wave component from a modulated wave signal (Sin). The extracted components are frequency shifted at a frequency shifter section (3) and combined at a combining section (4) into a combined modulated wave signal (Shdaa), which is in turn converted at an analog-to-digital converter (5) to combined modulated wave data (Dhdaa). A band-pass filter (6) extracts data (Dd) corresponding to the digital modulated wave component from the combined modulated wave data (Dhdaa), so that a digital broadcast demodulation section (8) demodulates the data (Dd). A band-pass filter (7) extracts data (Da) corresponding to the analog modulated wave component from the combined modulated wave data (Dhdaa), so that an analog broadcast demodulation section (9) demodulates the data (Da). In accordance with an error sense signal (ERR) detected at the digital broadcast demodulation section (8), a reception quality decision section (10) determines whether or not the reception quality is good. When the reception quality is good, a digital broadcast demodulated data (DMd) is output via a switching section (11), whereas when the reception quality has degraded, an analog broadcast demodulated data (DMa) is output via the switching section (11).

## Description

### Technical Field

The present invention relates to a receiver which demodulates a modulated wave having an analogly modulated wave component and a digitally modulated wave component, and to a demodulation method therefor.

### Background Art

Along with recent progress in use of multimedia information, various schemes of digital broadcasting are ready for service or in a preparatory stage for service.

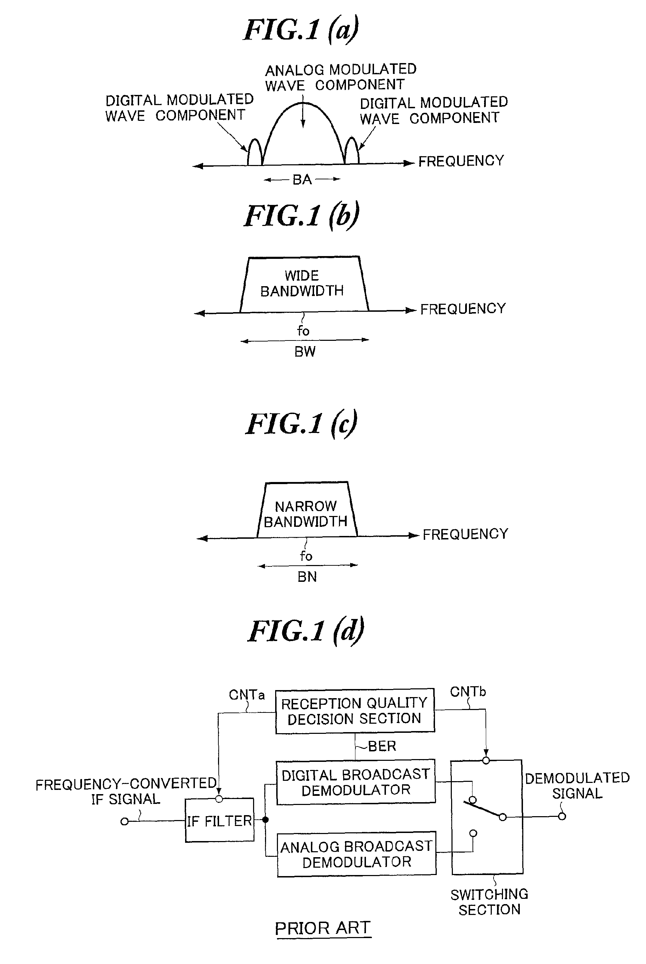

Examples include the IBOC (In-Band On-Channel) digital radio broadcasting in the United States. What is suggested in this example is as schematically illustrated in Fig. 1(a). That is, a predetermined frequency band for digital radio broadcasting is defined on each side of a broadcast channel frequency band BA that is assigned to existing analog radio broadcasting. Then, a modulated wave component of an analog radio broadcast program and modulated wave components of a digital radio broadcast program are broadcast on carriers (see Patent Document 1).

According to this broadcasting scheme, the transmission frequency band for the existing analog radio broadcasting needs not to be changed for use with analog radio broadcasting and digital radio broadcasting. It is thus thought that effective use can be made of the transmission frequency and good-quality digital radio broadcasting can be provided for users.

However, as can be seen from Fig. 1(a), the frequency band for digital radio broadcasting assigned on either side of the frequency band BA is set within the frequency band of an adjacent broadcast channel. Accordingly, the radio wave of the adjacent broadcast channel may overlap and interfere with the sideband region, which may thus suffer from the adjacent interference during reception of digital radio broadcasting.
Furthermore, for the digital radio broadcasting, the transmission path coding scheme is employed for full use of the capability of making error correction to fading or the like. However, the condition of incoming radio waves may degrade beyond the error correction capability, thereby causing degradation in the so-called reception quality. In this case, the reception quality of the digital radio broadcasting would become worse than that of the analog radio broadcasting.

In this context, such a receiver has been suggested which can be switched to receive analog radio broadcasting when digital radio broadcasting suffers from adjacent interference during its reception or the condition of incoming radio waves degrades thereby causing degradation in the reception quality.

Fig. 1(d) is a block diagram illustrating the configuration of the receiver. The receiver is configured to have an IF filter for receiving an IF signal which has been frequency converted (down-converted) to an intermediate frequency in a frontend section (not shown), a demodulator for digital broadcasting (digital broadcast demodulator), a demodulator for analog broadcasting (analog broadcast demodulator), a reception quality decision section, and a switching section.

The IF filter is formed of a tunable band-pass filter which switches between passband widths for the IF signal in accordance with a switching control signal CNTa from the reception quality decision section. The IF filter is adapted to switch between a wide bandwidth as shown in Fig. 1(b) and a narrow bandwidth as shown in Fig. 1(c). The wide bandwidth allows for passing the modulated wave components of both the analog radio broadcasting and the digital radio broadcasting, while the narrow bandwidth allows for passing only the modulated wave component of the analog radio broadcasting.

Suppose that the IF filter is switched to the wide bandwidth to receive a modulated wave component of digital radio broadcasting. In this case, the digital broadcast demodulator demodulates the component in conformity with the broadcasting scheme to produce a demodulated signal of a digital radio broadcast program for output via the switching section.

On the other hand, the digital broadcast demodulator performs an error correction process upon the demodulation to produce an error sense signal indicative of the level of reception quality from the signal being processed. For example, a modulated wave component of OFDM (orthogonal frequency division multiplexing) scheme digital radio broadcasting may be decoded or demodulated. In this case, a code error correction process is performed to detect a bit error rate BER indicative of the level of reception quality for output as an error sense signal.

Suppose that the IF filter is switched to the narrow bandwidth to receive a modulated wave component of analog radio broadcasting. In this case, the analog broadcast demodulator demodulates the component in conformity with the broadcasting scheme to produce a demodulated signal of an analog radio broadcast program for output via the switching section.

The switching section performs switching operations in accordance with a switching control signal CNTb from the reception quality decision section. When switching is made to the digital broadcast demodulator, the demodulated signal of the digital radio broadcast program is routed for output while the output from the analog broadcast demodulator is interrupted. On the other hand, when switching is made to the analog broadcast demodulator in accordance with the switching control signal CNTb, the demodulated signal of the analog radio broadcast program is routed for output while the demodulated signal of the digital radio broadcast program is interrupted.

The reception quality decision section receives the aforementioned error sense signal and determines whether the reception quality of the digital radio broadcasting is good or bad. Then, when the reception quality is determined to be good, the switching control signal CNTa allows the IF filter to be maintained on the wide bandwidth side and the switching section to remain connected to the digital broadcast demodulator.
This allows for outputting the demodulated signal of the digital radio broadcast program. On the other hand, when the reception quality is determined to have degraded, the switching control signal CNTa allows the IF filter to be switched to the narrow bandwidth and the switching section to be switched and connected to the analog broadcast demodulator. This allows for outputting the demodulated signal of the analog radio broadcast program.

As described above, when the reception quality has degraded during reception of digital radio broadcasting, the conventional receiver shown in Fig. 1(d) is switched to output the demodulated signal of the analog radio broadcast program. This allows listeners to be able to receive the analog radio broadcast program though it may have a degraded quality when compared to the primary quality of the digital radio broadcasting.

Patent Document 1: Japanese Unexamined Patent Application Publication No. 2002-529 955

### Disclosure of the Invention

### Problems to be Solved by the Invention

However, in the aforementioned conventional receiver shown in Fig. 1(d), when the reception quality has degraded so that the digital radio broadcasting is switched to the analog radio broadcasting for demodulation, the IF filter is switched to the narrow bandwidth. This causes the modulated wave component of the digital radio broadcasting to be no more supplied to the digital broadcast demodulator. Thus, an error such as the bit error rate BER cannot be detected any more.
Accordingly, the reception quality decision section cannot determine whether the reception quality has recovered to a good condition. Thus, there was such a problem that even when the reception quality has recovered to a good condition, the analog broadcasting cannot be automatically switched to the digital radio broadcasting for demodulation.

Thus, users who want to listen to primarily better-quality digital radio broadcast programs on a priority basis have to manually operate the receiver, as appropriate, in order to listen to the digital radio broadcast program. This raised a problem that good operability was not available.

The present invention was developed in view of these conventional problems. It is therefore an object of the present invention to provide a receiver which demodulates a modulated wave having an analog modulated wave component and a digital modulated wave component, and which is automatically switched to demodulate the digitally modulated wave component when its reception quality becomes good while the analog modulated wave component is being demodulated. It is another object of the invention to provide a demodulation method.

### Means for Solving the Problems

The invention according to claim 1 provides a receiver which demodulates a modulated wave having an analog modulated wave component and a digital modulated wave component. The receiver includes:
filter means for extracting the analog modulated wave component from the modulated wave signal and for extracting the analog modulated wave component
and the digital modulated wave component from the modulated wave signal as a completely modulated wave component;
frequency shifter means for frequency shifting at least one of the analog modulated wave component and the completely modulated wave component extracted by the filter means to a frequency region in which the components do not overlap each other;
combining means for combining the analog modulated wave component and the completely modulated wave component, which are shifted to the frequency region in which the components do not overlap each other, into a combined modulated wave signal;
an analog-to-digital converter for converting, from analog to digital, the combined modulated wave signal to combined modulated wave data; band-pass filter means
for extracting data corresponding to the digital modulated wave component from the combined modulated wave data and for extracting data corresponding to the analog modulated wave component from the combined modulated wave data;
digital broadcast demodulation means for demodulating the data corresponding to the digital modulated wave component extracted by the band-pass filter means; analog broadcast demodulation means for demodulating the data corresponding to the analog modulated wave component extracted by the band-pass filter means;
and reception quality decision means for determining whether or not the reception quality of the digital broadcasting is good in accordance with an error sense signal to be detected during the demodulation by the digital broadcast demodulation means.
The receiver is characterized in that when the reception quality decision means determines that the reception quality of the digital broadcasting has degraded, a demodulated signal having been demodulated at the analog broadcast demodulation means is allowed to be output. On the other hand, when the reception quality decision means determines that the reception quality of the digital broadcasting is good, a demodulated signal having been demodulated at the digital broadcast demodulation means is allowed to be output.

The invention according to claim 3 provides a demodulation method for demodulating a modulated wave having an analog modulated wave component and a digital modulated wave component. The method includes:
a filtering step of extracting the analog modulated wave component from the modulated wave signal and of extracting the analog modulated wave component and
the digital modulated wave component from the modulated wave signal as a completely modulated wave component;
a frequency shifting step of frequency shifting at least one of the analog modulated wave component and the completely modulated wave component extracted in the filter step to a frequency region in which the components do not overlap each other; a combining step of combining the analog modulated wave component and the completely modulated wave component, which are shifted to the frequency region in which the components do not overlap each other, into a combined modulated wave signal;
an analog-to-digital conversion step of converting, from analog to digital, the combined modulated wave signal to combined modulated wave data;
a band-pass filtering step of extracting data corresponding to the digital modulated wave component from the combined modulated wave data and of extracting data corresponding to the analog modulated wave component from the combined modulated wave data;
a digital broadcast demodulation step of demodulating the data corresponding to the digital modulated wave component extracted in the band-pass filtering step;
an analog broadcast demodulation step of demodulating the data corresponding to the analog modulated wave component extracted in the band-pass filtering step; and
a reception quality decision step of determining whether or not the reception quality of the digital broadcasting is good in accordance with an error sense signal to be detected during the demodulation in the digital broadcast demodulation step.
The method is characterized in that when the reception quality decision step determines that the reception quality of the digital broadcasting has degraded, a demodulated signal having been demodulated in the analog broadcast demodulation step is allowed to be output. On the other hand, when the reception quality decision step determines that the reception quality of the digital broadcasting is good, a demodulated signal having been demodulated in the digital broadcast demodulation step is allowed to be output.

### Brief Description of the Drawings

- Fig. 1: is an explanatory view illustrating the configuration and the function of a conventional digital radio broadcasting receiver.
- Fig. 2: is a block diagram illustrating the configuration of a receiver according to an embodiment of the present invention.
- Fig. 3: is an explanatory view illustrating the function of the receiver shown in Fig. 2.
- Fig. 4: is a block diagram illustrating the configuration of a receiver according to an implementation example.

### Best Mode for Currying Out the Invention

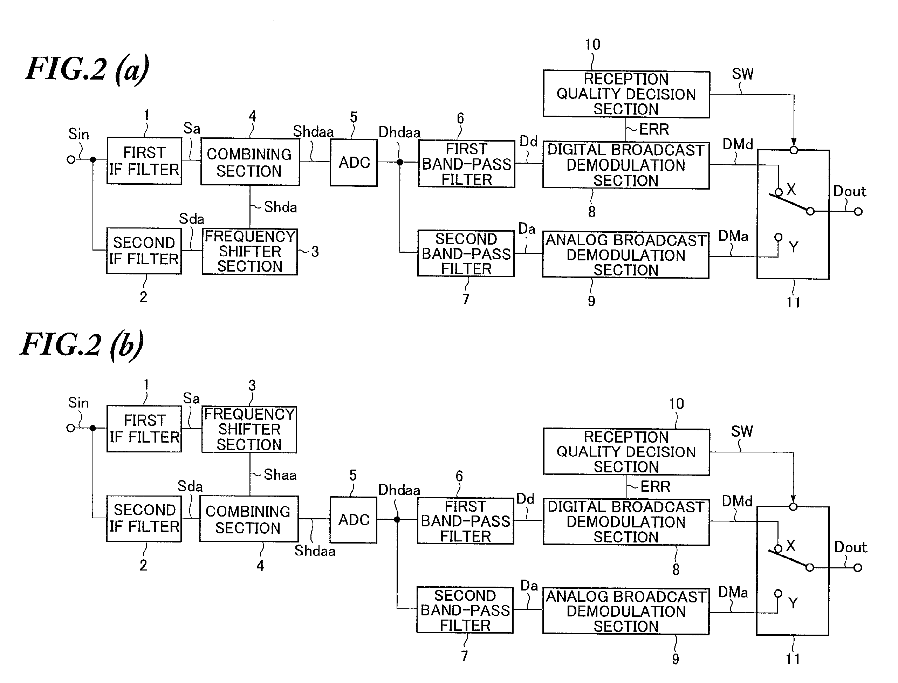

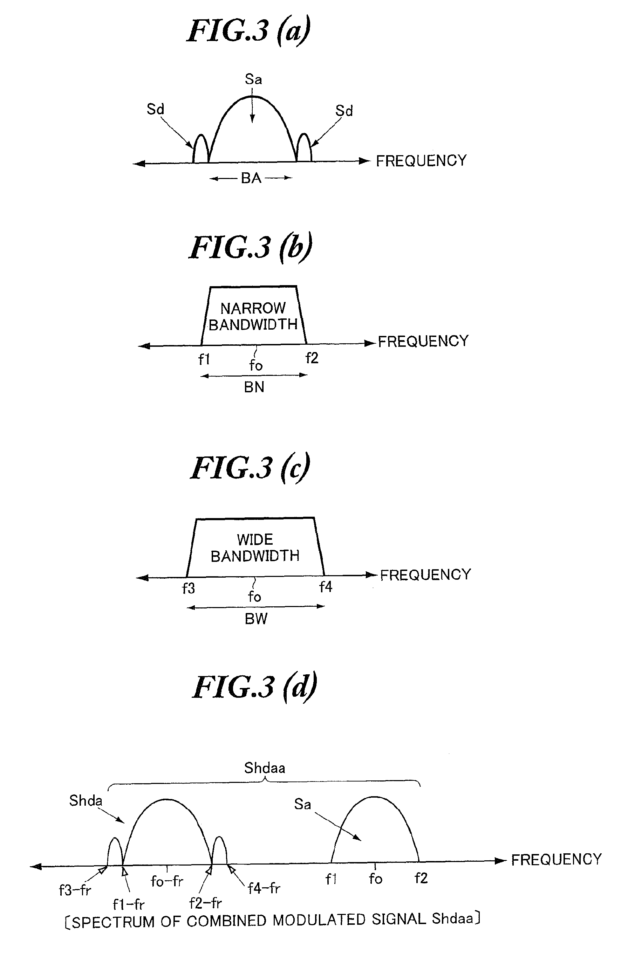

Now, with reference to Figs. 2 and 3, a description will be made to a preferred embodiment of the present invention. Fig. 2(a) is a block diagram illustrating the configuration of a receiver according to the present embodiment, Fig. 2(b) is a block diagram illustrating the configuration of a modified example of the present embodiment, and Figs. 3(a) to (d) are explanatory views illustrating the function thereof.

In Fig. 2(a), the receiver of the present embodiment is a receiver, for example, for the aforementioned IBOC digital radio broadcasting, which demodulates a modulated wave having an analogly modulated wave component and a digitally modulated wave component. The receiver is configured to have first and second IF filters 1 and 2 for receiving a modulated wave signal (IF signal) Sin produced in a frontend section (not shown), a frequency shifter section 3, a combining section 4, an analog-to-digital converter (ADC) 5, first and second band-pass filters 6 and 7, a digital broadcast demodulation section 8, an analog broadcast demodulation section 9, a reception quality decision section 10, and a switching section 11.

The first IF filter 1 is formed of a band-pass filter of a narrow bandwidth BN which allows an analogly modulated wave component (hereinafter referred to as the "analog modulated wave component") Sa contained in the modulated wave signal Sin to pass therethrough and rejects the passage of a digitally modulated wave component (hereinafter referred to as the "digital modulated wave component").

That is, as shown in Fig. 3(b), the passband width of the first IF filter 1 is set at the narrow bandwidth BN of frequency f1 to f2 to pass therethrough the analog modulated wave component Sa of the modulated wave signal Sin that has been frequency converted to an intermediate frequency. This corresponds to the fact that as schematically illustrated in Fig. 3(a), the frequency region of each broadcast channel has the frequency band BA of the analog modulated wave component Sa and the frequency band of a digital modulated wave component Sd on either side thereof.

The second IF filter 2 is formed of a band-pass filter of a wide bandwidth BW which passes therethrough the analog modulated wave component Sa and the digital modulated wave component Sd of the modulated wave signal Sin that has been frequency converted to the intermediate frequency. That is, as schematically illustrated in Fig. 3(c), the wide bandwidth BW of the second IF filter 2 is set at the frequency range from frequency f3 to f4 to pass therethrough the modulated wave component of both the analog modulated wave component Sa and the digital modulated wave component Sd (hereinafter referred to as the "completely modulated wave component") Sda.

The frequency shifter section 3 frequency shifts the completely modulated wave component Sda by a predetermined frequency fr for output as a shifted modulated wave component Shda. That is, the completely modulated wave component Sda is frequency shifted to a frequency region in order not to overlap with the aforementioned analog modulated wave component Sa.

The combining section 4 combines the analog modulated wave component Sa from the first IF filter 1 and the shifted modulated wave component Shda into a combined modulated wave signal Shdaa for output. As schematically illustrated in Fig. 3(d), in the combined modulated wave signal Shdaa, the analog modulated wave component Sa and the shifted modulated wave component Shda are to be positioned in different frequency regions.

The ADC 5 converts, from analog to digital, the combined modulated wave signal Shdaa to combined modulated wave data Dhdaa for output.

The first band-pass filter is formed of a digital bandpass filter which employs, as a passband width, the frequency range of frequency (f3-fr) to (f1-fr) and the frequency range of frequency (f2-fr) to (f4-fr), as shown in Fig. 3(d). This allows for extracting the data of the digital modulated wave component Sd (hereinafter referred to as the "digital modulated wave component data") Dd from the combined modulated wave data Dhdaa for output.

The second band-pass filter is formed of a digital bandpass filter which employs as a passband width the frequency range of frequency f1 to f2 as shown in Fig. 3(d). This allows for extracting the data of the analog modulated wave component Sa (hereinafter referred to as the "analog modulated wave component data") Da from the combined modulated wave data Dhdaa for output.

The digital broadcast demodulation section 8 receives the digital modulated wave component data Dd, which is then demodulated (or subjected to digital signal processing) in conformity with the broadcasting scheme for the broadcast being received, thereby reproducing the demodulated data DMd of a digital broadcast program for output. Furthermore, the digital broadcast demodulation section 8 makes an error correction during the demodulation process, and produces error sense data ERR indicative of the level of reception quality from the data being processed. For example, while an OFDM-scheme digital radio broadcast is being received, a code error correction is made to detect a bit error rate (BER) indicative of the level of reception quality for output as the error sense data ERR.

The analog broadcast demodulation section 9 receives the analog modulated wave component data Da, which is then demodulated (or subjected to analogue signal processing) in conformity with the broadcasting scheme for the broadcast being received, thereby reproducing the demodulated data DMa of an analog broadcast program for output.

The switching section 11 performs switching operations in accordance with a switching control signal SW from the reception quality decision section 10. When switching is made to an input contact X on the side of the digital broadcast demodulation section 8, the demodulated data DMd of the digital radio broadcast program is routed for output, and the output from the analog broadcast demodulation section 9 is interrupted.
On the other hand, when switching is made to an input contact Y on the side of the analog broadcast demodulation section 9 in accordance with the switching control signal SW, the demodulated data DMa of the analog radio broadcast program is routed for output, and the output from the analog broadcast demodulation section 9 is interrupted. In this manner, in accordance with the command of the switching control signal SW, the switching section 11 outputs the demodulated data DMd or DMa as a demodulated signal (baseband signal) Dout.

The reception quality decision section 10 compares the aforementioned error sense data ERR to the predetermined decision reference, thereby determining whether the reception quality of the digital radio broadcasting is good or bad. Then, when the reception quality is determined to be good, the switching control signal SW is used to control the switching section 11, thereby making a connection to the input contact X.
On the other hand, when the reception quality is determined to have degraded, the switching control signal SW is used to control the switching section 11, thereby making a connection to the input contact Y. For example, while an OFDM-scheme digital radio broadcast is being received, the data value of the bit error rate (BER) produced in the digital broadcast demodulation section 8 during the code error correction process is compared to the decision reference value. It is then checked whether the data value of the bit error rate (BER) is indicative of a good reception quality with respect to the decision reference, thereby determining whether or not the reception quality is good.

A description will now be made to the operation of the receiver configured in this manner. The first IF filter 1 of the narrow bandwidth BN and the second IF filter 2 of the wide bandwidth BW extract the analog modulated wave component Sa and the completely modulated wave component Sda, respectively, from the modulated wave signal Sin supplied. The frequency shifter section 3 frequency shifts the completely modulated wave component Sda to the shifted modulated wave component Shda.
The combining section 4 combines the analog modulated wave component Sa and the shifted modulated wave component Shda into the combined modulated wave signal Shdaa. The ADC 5 converts, from analog to digital, the combined modulated wave signal Shdaa to the combined modulated wave data Dhdaa for supply to the first band-pass filter 6 and the second band-pass filter 7.
The digital modulated wave component data Dd, which is a modulated wave component Sd of the digital broadcast program, is extracted and supplied to the digital broadcast demodulation section 8. At the same time, the analog modulated wave component data Da, which is a modulated wave component Sa of the analog broadcast program, is extracted and supplied to the analog broadcast demodulation section 9.

Then, the digital broadcast demodulation section 8 performs the predetermined demodulation process in accordance with the digital modulated wave component data Dd to thereby reproduce the demodulated data DMd. The analog broadcast demodulation section 9 performs the predetermined demodulation process in accordance with the analog modulated wave component data Da to thereby reproduce the demodulated data DMa.

Here, while sequentially comparing the error sense data ERR produced in the digital broadcast demodulation section 8 to the decision reference, the reception quality decision section 10 determines whether or not the reception quality of the digital broadcasting is good. When the reception quality is determined to be good, the switching control signal SW allows the switching section 11 to be connected to the contact X, thereby outputting the demodulated data DMd of the digital broadcast program as the demodulated signal Dout. On the other hand, when the reception quality is determined to have degraded, the switching control signal SW allows the switching section 11 to be connected to the contact Y, thereby outputting the demodulated data DMa of the analog broadcast program as the demodulated signal Dout.

That is, the reception quality may be determined to be good while the demodulated data DMd of the digital broadcast program is being delivered as the demodulated signal Dout with the switching section 11 connected to the contact X. In this case, the reception quality decision section 10 allows the demodulated data DMd to be continually output. On the other hand, the reception quality may be determined to have degraded while the demodulated data DMd of the digital broadcast program is being delivered as the demodulated signal Dout. In this case, the reception quality decision section 10 allows the switching section 11 to be connected to the contact Y, so that the demodulated data DMa of the analog broadcast program is delivered as the demodulated signal Dout.

Furthermore, the reception quality may be determined to have degraded while the demodulated data DMa of the analog broadcast program is being delivered as the demodulated signal Dout with the switching section 11 connected to the contact Y. In this case, the demodulated data DMa is continually output. On the other hand, the reception quality may be determined to be good while the demodulated data DMa of the analog broadcast program is being delivered as the demodulated signal Dout. In this case, the switching section 11 is connected to the contact X, so that the demodulated data DMd of the digital broadcast program is delivered as the demodulated signal Dout.

As described above, according to the receiver of the present embodiment, the first and second IF filters 1 and 2, the frequency shifter section 3, the combining section 4, and the ADC 5 produce the combined modulated wave data Dhdaa which contains the shifted modulated wave component Shda and the analog modulated wave component Sa, which have different frequency regions. Then, the first band-pass filter 6 extracts the digital modulated wave component data Dd from the combined modulated wave data Dhdaa for supply to the digital broadcast demodulation section 8.
At the same time, the second band-pass filter 7 extracts the analog modulated wave component data Da from the combined modulated wave data Dhdaa for supply to the analog broadcast demodulation section 9. Accordingly, during reception of broadcasts, the digital broadcast demodulation section 8 performs the demodulation process all the time in accordance with the digital modulated wave component data Dd, and performs the code error correction process to produce the error sense data ERR.

Accordingly, even when the reception quality has degraded with the demodulated data DMa of the analog broadcast program being delivered, the reception quality decision section 10 can determine whether or not the reception quality is good, in accordance with the error sense data ERR. When the reception quality is determined to be good, automatic switching control is provided to the switching section 11, thereby allowing the demodulated data DMd of the digital broadcast program to be output. It is thus possible to provide primarily good-quality digital broadcast programs to users on a priority basis.

Furthermore, the frequency characteristics of the first and second IF filters 1 and 2 and the first and second band-pass filters 6 and 7 do not need to be changed in accordance with the result of a decision made by the reception quality decision section 10.
It is thus possible to form those filters of an untunable filter. This makes it possible to implement a receiver which operates with stability. It is also possible to employ those circuits which are simplified in configuration and reduced in size. For example, semiconductor integrated circuit devices (such as ICs or MSIs) can be used to provide outstanding effects.

Furthermore, the present embodiment described above is configured such that the combining section 4 produces the combined modulated wave signal Shdaa, which is then converted from analog to digital in the ADC 5. This eliminates the need of a plurality of analog-to-digital converters for supplying the data Dd and Da of the digital modulated wave component Sd and the analog modulated wave component Sa to the digital broadcast demodulation section 8 which performs digital signal processing for demodulation and the analog broadcast demodulation section 9. This allows for reducing the scale of the circuit.

In the configuration of the receiver shown in Fig. 2(a), the completely modulated wave component Sda extracted by the second IF filter 2 of the wide bandwidth BW is frequency shifted in the frequency shifter section 3, thereby producing the shifted modulated wave component Shda. The shifted modulated wave component Shda and the analog modulated wave component Sa extracted by the first IF filter 1 of the narrow bandwidth BN are combined in the combining section 4 into the combined modulated wave signal Shdaa.
However, alternatively, as shown in Fig. 2(b), the analog modulated wave component Sa extracted by the first IF filter 1 may be frequency shifted in the frequency shifter section 3 to produce a shifted modulated wave component Shaa. Then, the shifted modulated wave component Shaa and the completely modulated wave component Sda extracted by the second IF filter 2 of the wide bandwidth BW may be combined in the combining section 4 into the combined modulated wave signal Shdaa.

When the configuration shown in Fig. 2(b) is employed, the analog modulated wave component Sa contained in the combined modulated wave signal Shdaa has a frequency band of frequency (f1-fr) to (f4-fr), while the shifted modulated wave component Shaa has a frequency band of frequency f3 to f4. The passband width of the first band-pass filter 6 may be defined in the frequency range of frequency f3 to f1 and the frequency range of frequency f2 to f4, while the passband width of the second band-pass filter 7 may be defined in the frequency range of frequency (f1-fr) to (f4-fr). This can provide the same effects as those of the receiver configured as shown in Fig. 2(a).

Furthermore, in the description above, the frequency shifter section 3 shown in Fig. 2(a) is configured such that the completely modulated wave component Sda is frequency shifted to a frequency region lower than the band of the modulated wave signal Sin. In contrast, the frequency shifter section 3 shown in Fig. 2(b) is configured such that the analog modulated wave component Sa is frequency shifted to a frequency region lower than the band of the modulated wave signal Sin.
However, the completely modulated wave component Sda and the analog modulated wave component Sa may also be frequency shifted to a frequency region higher than the band of the modulated wave signal Sin (i.e., subjected to a so-called up-conversion). Then, the passband widths of the first and second band-pass filters 6 and 7 may be determined so as to extract the data Dd and Da of the digital modulated wave component Sd and the analog modulated wave component Sa, whose position on the frequency axis is to be shifted by those frequency shifts.

Furthermore, not only one of the outputs from the first and second IF filters 1 and 2 is frequency shifted, but both the outputs may be frequency shifted. Thus, the digital modulated wave component Sd and the analog modulated wave component Sa to be contained in the combined modulated wave signal Shdaa do not overlap each other on the frequency axis. Then, the passband widths of the first and second band-pass filters 6 and 7 may be determined so as to extract the data Dd and Da of the digital modulated wave component Sd and the analog modulated wave component Sa.

Essentially, at least one of the outputs from the first and second IF filters 1 and 2 may be frequency shifted, so that the digital modulated wave component Sd and the analog modulated wave component Sa to be contained in the combined modulated wave signal Shdaa do not overlap each other on the frequency axis. Then, the passband widths of the first and second band-pass filters 6 and 7 may be determined so as to extract the data Dd and Da of the digital modulated wave component Sd and the analog modulated wave component Sa.

In this manner, the frequency shift methods can be selected as appropriate. For example, this allows for providing the optimal operating frequency to the ADC 5 in accordance with design specifications. It is also possible to optimize the characteristics of the first and second IF filters 1 and 2 or the first and second band-pass filters 6 and 7, and the operating frequency of the receiver.

Furthermore, the modulated signal Sin may be converted to digital data in advance by analog-to-digital conversion for supply to the first and second IF filters 1 and 2, so that the first and second IF filters 1 and 2, the frequency shifter section 3, and the combining section 4 can be formed of a digital signal processing circuit. Such a configuration allows the combining section 4 to output combined modulated wave data Shdaa, with the result that the ADC 5 can be eliminated.

Furthermore, all the components described above from the first and second IF filters 1 and 2 to the switching section 11 may be formed of hardware such as transistor circuits or semiconductor integrated circuit devices. Alternatively, a computer program may also be prepared which functions in the same manner as the hardware does. Then, DSPs (digital signal processors) or MPUs (microprocessors) may be operated in accordance with the computer program, i.e., so-called firmware-driven software communications may be carried out.

### Example 1

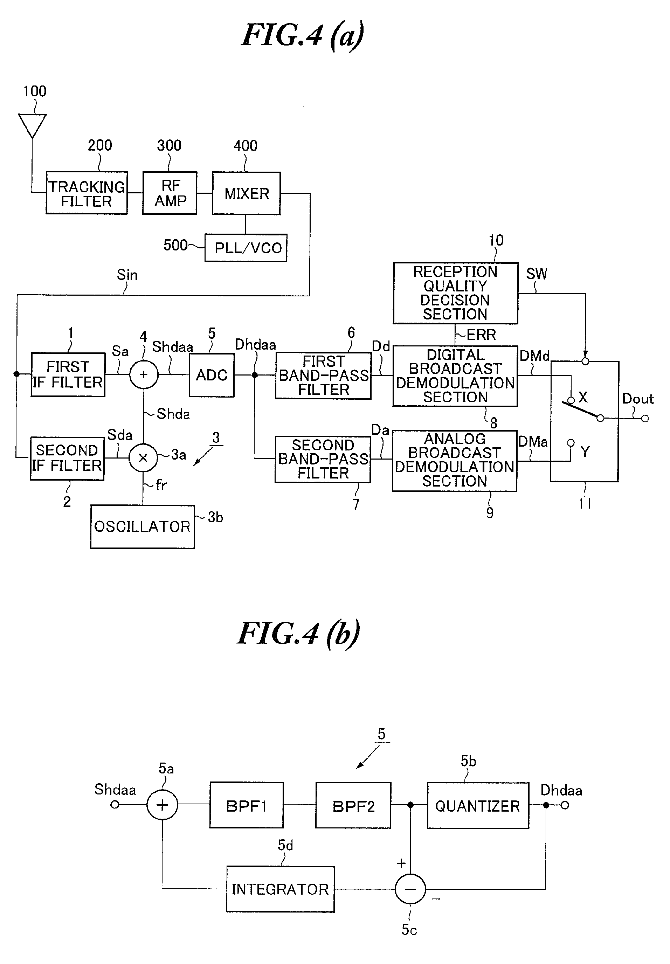

Now, with reference to Fig. 4, a description will be made to a more specific example. Note that Fig. 4(a) is a block diagram illustrating the configuration of the receiver of the present example, in which the components that are the same as or equivalent to those of Fig. 2(a) are indicated with like symbols. Fig. 4(b) is a block diagram illustrating the configuration of the ADC 5.

The receiver of the present example is a receiver for digital radio broadcasting, such as IBOC digital radio broadcasting, which demodulates a modulated wave having an analog modulated wave component and a digital modulated wave component.

Furthermore, as shown in Fig. 4(a), this receiver is configured to have an antenna 100 for receiving incoming radio waves, a tracking filter 200 and an RF amplifier 300 for selectively amplifying a received high-frequency signal received within the broadcast band by the antenna 100. The receiver further includes a local signal oscillator 500 having a PLL (Phase Locked Loop) circuit and a VCO (Voltage Controlled Oscillator) circuit, and a mixer 400. The mixer 400 mixes the received high-frequency signal delivered from the RF amplifier 300 with a local signal delivered from the local signal oscillator 500 to thereby produce a modulated signal of an intermediate frequency (hereinafter referred to as "IF signal") Sin for output.
In addition to these components, the receiver also includes the first and second IF filters 1 and 2, a multiplier 3a, an oscillator 3b, an adder 4, the analog-to-digital converter (ADC) 5, the first and second digital bandpass filters 6 and 7, the digital broadcast demodulation section 8, the analog broadcast demodulation section 9, the reception quality decision section 10, and the switching section 11.

As shown in Fig. 3(b), the first IF filter 1 is formed of a band-pass filter of the narrow bandwidth BN with a passband of frequency f1 to f2 around a center frequency fo to extract the analog modulated wave component Sa of an analog broadcast program from the IF signal Sin for output.

As shown in Fig. 3(c), the second IF filter 2 is formed of a band-pass filter of the wide bandwidth BW with a passband of frequency f3 to f4 around a center frequency fo. The second IF filter 2 extracts the completely modulated wave component Sda, which contains the analog modulated wave component Sa and the digital modulated wave component Sd of a digital broadcast program, from the IF signal Sin for output.

The multiplier 3a and the oscillator 3b are equivalent to the frequency shifter section 3 shown in Fig. 2(a). The oscillator 3b generates an oscillated signal at a predetermined frequency fr for frequency shifting. The multiplier 3a multiplies the oscillated signal by the completely modulated wave component Sda, thereby producing the shifted modulated wave component Shda. Note that in the present example, the frequency fr of the aforementioned oscillated signal is set at a frequency for down-converting the completely modulated wave component Sda to a frequency region that is lower than that of the analog modulated wave component Sa.

The adder 4 is equivalent to the combining section 4 shown in Fig. 2(a). The adder 4 adds the shifted modulated wave component Shda to the analog modulated wave component Sa, thereby producing the combined modulated wave signal Shdaa for output. As shown in Fig. 3(d), this allows for producing the combined modulated wave signal Shdaa in which the analog modulated wave component Sa and the shifted modulated wave component Shda are to be positioned in different frequency regions.

The ADC 5 is formed of a Delta-Sigma scheme analog-to-digital converter (ΔΣADC), and converts, from analog to digital, the combined modulated wave signal Shdaa to the combined modulated wave data Dhdaa for output.

Here, as shown in Fig. 4(b), the ADC 5 is configured to have: an adder 5a; a band-pass filter BPF 1 having a passband width that agrees with the band of the shifted modulated wave component Shda (i.e., the frequency range of frequency (f3-fr) to (f4-fr)); a band-pass filter BPF2 having a passband width that agrees with the band of the analog modulated wave component Sa (i.e., the frequency range of frequency f1 to f2); a quantizer 5b; a subtractor 5c; and an integrator 5d. The ADC 5 operates at an oversampling frequency that is sufficiently higher than the maximum frequency (f2 in the present example) of the combined modulated wave signal Shdaa.

Then, the adder 5a adds the combined modulated wave signal Shdaa to the output from the integrator 5d. The band-pass filters BPF1 and BPF2 filter the result of the addition for output. The quantizer 5b quantizes the output to the predetermined stages, thereby producing the combined modulated wave data Dhdaa for output. Furthermore, the subtractor 5c computes the difference between the input to and the output (the combined modulated wave data Dhdaa) from the quantizer 5b. Then, the integrator 5d integrates (i.e., converts from digital to analog) the resulting difference for supply to the adder 5a.

The ADC 5 configured as such can make use of noise shaping characteristics in accordance with the passband of the band-pass filters BPF1 and BPF2 to produce the combined modulated wave data Dhdaa with a good S/N.

As shown in Fig. 3(d), the first band-pass filter is formed of a digital bandpass filter of a passband width which includes the frequency range of frequency (f3-fr) to (f1-fr) and the frequency range of frequency (f2-fr) to (f4-fr). The first band-pass filter extracts the digital modulated wave component data Dd from the combined modulated wave data Dhdaa for output.

As shown in Fig. 3(d), the second band-pass filter is formed of a digital bandpass filter of a passband width which includes the frequency range of frequency f1 to f2, and extracts the analog modulated wave component data Da from the combined modulated wave data Dhdaa for output.

The digital broadcast demodulation section 8 receives the digital modulated wave component data Dd, which is then demodulated in conformity with the broadcasting scheme for the broadcast being received, thereby reproducing the demodulated data DMd of the digital broadcast program for output. Furthermore, the digital broadcast demodulation section 8 makes an error correction during the demodulation process to produce the error sense data ERR indicative of the level of reception quality from the data being processed. For example, while an OFDM-scheme digital radio broadcast is being received, a code error correction is made to detect the bit error rate (BER) indicative of the level of reception quality for output as the error sense data ERR.

The analog broadcast demodulation section 9 receives the analog modulated wave component data Da, which is then demodulated in conformity with the broadcasting scheme for the broadcast being received, thereby reproducing the demodulated data DMa of the analog broadcast program for output.

The switching section 11 performs switching operations in accordance with the switching control signal SW from the reception quality decision section 10. When switching is made to the input contact X on the side of the digital broadcast demodulation section 8, the demodulated data DMd of the digital radio broadcast program is routed for output, and the output from the analog broadcast demodulation section 9 is interrupted.
On the other hand, when switching is made to the input contact Y on the side of the analog broadcast demodulation section 9 in accordance with the switching control signal SW, the demodulated data DMa of the analog radio broadcast program is routed for output, and the output from the analog broadcast demodulation section 9 is interrupted.

The reception quality decision section 10 compares the aforementioned error sense data ERR to the predetermined decision reference, thereby determining whether the reception quality of the digital radio broadcasting is good or bad. Then, when the reception quality is determined to be good, the switching control signal SW is used to control the switching section 11, thereby making a connection to the input contact X.
On the other hand, when the reception quality is determined to have degraded, the switching control signal SW is used to control the switching section 11, thereby making a connection to the input contact Y. For example, while an OFDM-scheme digital radio broadcast is being received, the data value of the bit error rate (BER) produced in the digital broadcast demodulation section 8 during the code error correction process is compared to the decision reference value.
It is then checked whether the data value of the bit error rate (BER) is indicative of a good reception quality with respect to the decision reference, thereby determining whether or not the reception quality is good.

A description will now be made to the operation of the receiver of the present example configured in this manner.

The first IF filter 1 of the narrow bandwidth BN and the second IF filter 2 of the wide bandwidth BW extract the analog modulated wave component Sa and the completely modulated wave component Sda, respectively, from the modulated wave signal Sin supplied. The multiplier 3a multiplies the completely modulated wave component Sda by the oscillated signal of frequency fr to produce the shifted modulated wave component Shda which has been frequency shifted by frequency fr. Then, the adder 4 adds the analog modulated wave component Sa to the shifted modulated wave component Shda, thereby producing the combined modulated wave signal Shdaa.

The ADC 5 which makes full use of noise shaping characteristics converts, from analog to digital, the combined modulated wave signal Shdaa to the combined modulated wave data Dhdaa for supply to the first band-pass filter 6 and the second band-pass filter 7. The digital modulated wave component data Dd, which is the modulated wave component Sd of the digital broadcast program, is extracted and supplied to the digital broadcast demodulation section 8. At the same time, the analog modulated wave component data Da, which is the modulated wave component Sa of the analog broadcast program, is extracted and supplied to the analog broadcast demodulation section 9.

Then, the digital broadcast demodulation section 8 performs the predetermined demodulation process in accordance with the digital modulated wave component data Dd to thereby reproduce the demodulated data DMd. The analog broadcast demodulation section 9 performs the predetermined demodulation process in accordance with the analog modulated wave component data Da to thereby reproduce the demodulated data DMa.

Here, while sequentially comparing the error sense data ERR produced in the digital broadcast demodulation section 8 to the decision reference, the reception quality decision section 10 determines whether or not the reception quality of the digital broadcasting is good.
When the reception quality is determined to be good, the switching control signal SW allows the switching section 11 to be connected to the contact X, thereby outputting the demodulated data DMd of the digital broadcast program as the demodulated signal Dout. On the other hand, when the reception quality is determined to have degraded, the switching control signal SW allows the switching section 11 to be connected to the contact Y, thereby outputting the demodulated data DMa of the analog broadcast program as the demodulated signal Dout.

That is, the reception quality may be determined to be good while the demodulated data DMd of the digital broadcast program is being delivered as the demodulated signal Dout with the switching section 11 connected to the contact X. In this case, the reception quality decision section 10 allows the demodulated data DMd to be continually output.
On the other hand, the reception quality may be determined to have degraded while the demodulated data DMd of the digital broadcast program is being delivered as the demodulated signal Dout. In this case, the reception quality decision section 10 allows the switching section 11 to be connected to the contact Y, so that the demodulated data DMa of the analog broadcast program is delivered as the demodulated signal Dout.

Furthermore, the reception quality may be determined to have degraded while the demodulated data DMa of the analog broadcast program is being delivered as the demodulated signal Dout with the switching section 11 connected to the contact Y. In this case, the demodulated data DMa is continually output. Still furthermore, the reception quality may be determined to be good while the demodulated data DMa of the analog broadcast program is being delivered as the demodulated signal Dout. In this case, the switching section 11 is connected to the contact X, so that the demodulated data DMd of the digital broadcast program is delivered as the demodulated signal Dout.

As described above, according to the receiver of the present example, the first and second IF filters 1 and 2, the multiplier 3a, the oscillator 3b, the adder 4, and the ADC 5 produce the combined modulated wave data Dhdaa which contains the shifted modulated wave component Shda and the analog modulated wave component Sa, which have different frequency regions. Then, the first band-pass filter 6 extracts the digital modulated wave component data Dd from the combined modulated wave data Dhdaa for supply to the digital broadcast demodulation section 8.
At the same time, the second band-pass filter 7 extracts the analog modulated wave component data Da from the combined modulated wave data Dhdaa for supply to the analog broadcast demodulation section 9. Accordingly, during reception of broadcasts, the digital broadcast demodulation section 8 performs the demodulation process all the time in accordance with the digital modulated wave component data Dd, and performs the code error correction process to produce the error sense data ERR.

Accordingly, even when the reception quality has degraded with the demodulated data DMa of the analog broadcast program being delivered, the reception quality decision section 10 can determine whether or not the reception quality is good, in accordance with the error sense data ERR. When the reception quality is determined to be good, automatic switching control is provided to the switching section 11, thereby allowing the demodulated data DMd of the digital broadcast program to be output. It is thus possible to provide primarily good-quality digital broadcast programs to users on a priority basis.

Furthermore, since the ADC 5 is formed of a ΔΣADC which makes full use of noise shaping characteristics, it is possible to reproduce the demodulated signal Dout with a good S/N.

Furthermore, the frequency characteristics of the first and second IF filters 1 and 2 and the first and second band-pass filters 6 and 7 do not need to be changed in accordance with the result of a decision made by the reception quality decision section 10. It is thus possible to form those filters of an untunable filter. This makes it possible to implement a receiver which operates with stability. It is also possible to employ those circuits which are simplified in configuration and reduced in size. For example, semiconductor integrated circuit devices (such as ICs or MSIs) can be used to provide outstanding effects.

Furthermore, a single ADC 5 is used for analog-to-digital conversion of the combined modulated wave signal Shdaa, which contains the shifted modulated wave component Shda and the analog modulated wave component Sa, to the combined modulated wave data Dhdaa. This allows for reducing the scale of the circuit.

Note that all the components described above from the first and second IF filters 1 and 2 to the switching section 11 may be formed of hardware such as transistor circuits or semiconductor integrated circuit devices. Alternatively, a computer program may also be prepared which functions in the same manner as the hardware does. Then, DSPs (digital signal processors) or MPUs (microprocessors) may be operated in accordance with the computer program, i.e., so-called software communications may be carried out.

## Claims

1. A receiver for demodulating a modulated wave having an analog modulated wave component and a digitally modulated wave component, the receiver comprising:
- filter means for extracting the analog modulated wave component from the modulated wave signal and for extracting the analog modulated wave component and the digitally modulated wave component from the modulated wave signal as a completely modulated wave component;
- frequency shifter means for frequency shifting at least one of the analog modulated wave component and the completely modulated wave component extracted by the filter means to a frequency region in which the components do not overlap each other;
- combining means for combining the analog modulated wave component and the completely modulated wave component, which have been shifted to the frequency region in which the components do not overlap each other, into a combined modulated wave signal;
- an analog-to-digital converter for converting, from analog to digital, the combined modulated wave signal to combined modulated wave data;
- band-pass filter means for extracting data corresponding to the digitally modulated wave component from the combined modulated wave data and for extracting data corresponding to the analog modulated wave component from the combined modulated wave data;
- digital broadcast demodulation means for demodulating the data corresponding to the digitally modulated wave component extracted by the band-pass filter means;
- analog broadcast demodulation means for demodulating the data corresponding to the analog modulated wave component extracted by the band-pass filter means; and
- reception quality decision means for determining whether or not the reception quality of the digital broadcasting is good in accordance with an error detection signal to be detected during the demodulation by the digital broadcast demodulation means,
- wherein, when the reception quality decision means determines that the reception quality of the digital broadcasting has degraded, a demodulated signal having been demodulated at the analog broadcast demodulation means is allowed to be output; and, when the reception quality decision means determines that the reception quality of the digital broadcasting is good, a demodulated signal having been demodulated at the digital broadcast demodulation means is allowed to be output.

2. The receiver according to claim 1,
wherein the analog-to-digital converter is a Delta-Sigma analog-to-digital converter which makes full use of noise shaping characteristics.

3. A demodulation method for demodulating a modulated wave having an analog modulated wave component and a digitally modulated wave component, the method comprising:
- a filtering step of extracting the analog modulated wave component from the modulated wave signal and of extracting the analog modulated wave component and the digitally modulated wave component from the modulated wave signal as a completely modulated wave component;
- a frequency shifting step of frequency shifting at least one of the analog modulated wave component and the completely modulated wave component extracted in the filtering step to a frequency region in which the components do not overlap each other;
- a combining step of combining the analog modulated wave component and the completely modulated wave component, which have been shifted to the frequency region in which the components do not overlap each other, into a combined modulated wave signal;
- an analog-to-digital conversion step of converting, from analog to digital, the combined modulated wave signal to combined modulated wave data;
- a band-pass filter step of extracting data corresponding to the digitally modulated wave component from the combined modulated wave data and of extracting data corresponding to the analog modulated wave component from the combined modulated wave data;
- a digital broadcast demodulation step of demodulating the data corresponding to the digitally modulated wave component extracted in the band-pass filtering step;
- an analog broadcast demodulation step of demodulating the data corresponding to the analog modulated wave component extracted in the band-pass filtering step; and
- a reception quality decision step of determining whether or not the reception quality of the digital broadcasting is good in accordance with an error detection signal to be detected during the demodulation in the digital broadcast demodulation step,
- wherein, when the reception quality decision step determines that the reception quality of the digital broadcasting has degraded, a demodulated signal having been demodulated in the analog broadcast demodulation step is allowed to be output; and, when the reception quality decision step determines that the reception quality of the digital broadcasting is good, a demodulated signal having been demodulated in the digital broadcast demodulation step is allowed to be output.
